# EUROPÄISCHE PATENTSCHRIFT

(11) **EP 0 400 337 B1**
(45) Veröffentlichungstag und Bekanntmachung des Hinweises auf die Patenterteilung: **30.06.1993**
(21) Anmeldenummer: 90108179.4
(22) Anmeldetag: 28.04.1990
(51) Int. Cl.: H04N 5/44, H04N 5/64

(54) **Fernbediengerät für ein Fernsehgerät**
Remote control device for a television receiver
Appareil de télécommande pour récepteur de télévision

(30) Priorität: 02.06.1989 DE 3917958
(43) Veröffentlichungstag der Anmeldung: 05.12.1990
(73) Patentinhaber: Preh-Werke GmbH & Co. KG, 97616 Bad Neustadt (DE)
(72) Erfinder: Brüggemann, Ulrich, Dipl.-Ing., D-8741 Heustreu (DE)

(56) Entgegenhaltungen:
- DE-A- 2 215 329
- DE-B- 2 154 663
- DE-B- 2 612 260

## Beschreibung

Die Erfindung betrifft ein Fernbediengerät für ein Fernsehgerät mit mehreren Programmwahltasten und mit einer Infrarot-Sendeschaltung, die Signale betätigter Tasten zum Fernsehgerät abstrahlt.

Derartige Fernbediengeräte sind bekannt. Häufig ist am Fernsehgerät neben der Bildröhre ein Anzeigefeld vorgesehen, das die mittels des Fernbediengerätes getroffene Programmauswahl anzeigt.

Es sind auch Fernsehgeräte bekannt, bei denen in das Bild eines laufenden Programms ein Bild eines weiteren Programms einzublenden ist. Ein solches Fernsehgerät ist mit zwei Tunern ausgestattet, wobei der erste Tuner die Video- und Audiosignale der empfangenen Hauptsendung empfängt und der zweite Tuner nur die Videosignale eines anderen Programms empfängt. Beide Tuner werden vom gleichen Programmspeicher gesteuert. Ein derartiges Fernsehgerät ist in der Firmenschrift ITT, "IC-Satz für Bild im Bild", Nr. 6521-117-3D, April 1978 beschrieben.

Es wurde auch vorgeschlagen, das Fernsehbild des Fernsehgeräts in vier, neun oder sechzehn gleich große Flächen aufzuteilen, wobei auf jeder dieser Flächen eines der wählbaren Programme in Form sich ständig erneuernder Standbilder erscheint (vgl. Katalog der Fa. SONY, Programm 88/89, S.23). Hierbei empfängt der Tuner der Reihe nach die im Programmspeicher vorgesehenen Programme, reduziert den Bildinhalt, digitalisiert diesen und legt das so gewonnene Bild in einem Speicher ab. Die Bilder erscheinen nach dem Digitalisieren auf dem entsprechenden Bereich des Bildschirms des Fernsehgeräts. Beispielsweise erscheinen alle 2 bis 5 s neue Bilder aus den Programmen. Eine gleichzeitige, durchgehende Betrachtung eines Programms, also eine Betrachtung ohne Standbilder, ist dabei nicht möglich.

Für kleine Bildschirme an Fernsehgeräten werden oft Flüssigkristallanzeigen verwendet. Bei diesen liegen zwischen Glasscheiben Dünnfilmtransistoren oder nicht lineare Elemente zur Ansteuerung der einzelnen Bildpunkte. Solche Flüssigkristallanzeigen sind in Peter M. Knoll, Displays Einführung in die Technik aktiver und passiver Anzeigen, Dr. Alfred Hüthig-Verlag, Heidelberg, 1986, S. 216-220 beschrieben.

In der DE-A- 33 22 729 ist ein Fernbediengerät beschrieben, das neben einem Sender einen Empfänger aufweist. Durch ein Signal des Fernsehgeräts wird das Fernbediengerät bereitgeschaltet. Die Bedienbereitschaft wird angezeigt.

Aufgabe der Erfindung ist es, ein Fernbediengerät für ein Fernsehgerät vorzuschlagen, mit dem für den Benutzer die Auswahl eines Fernsehprogramms dadurch erleichtert ist, daß ihm am Fernbediengerät selbst Bilder aus den jeweils gebotenen, auswählbaren Programmen gezeigt werden.

Erfindungsgemäß ist obige Aufgabe bei einem Fernbediengerät der eingangs genannten Art dadurch gelöst, daß das Fernbediengerät eine Empfangsschaltung aufweist, die Bildsignale der mittels der Programmwahltasten auswählbaren Fernsehprogramme erfaßt, daß ein Speicher diese Bildsignale erforderlichenfalls speichert, daß jeder Programmwahltaste am Fernbediengerät ein Bildanzeigefeld zugeordnet ist und daß eine Steuerschaltung die Bildsignale aus dem Speicher zyklisch auf die Bildanzeigefelder verteilt.

An diesem Fernbediengerät sind für den Benutzer die jeweils aktuellen Bilder aus den wählbaren Programmen sichtbar. Die am Bildschirm des Fernsehgeräts laufende Sendung ist dadurch nicht unterbrochen. Der Benutzer kann die Sendung am Bildschirm des Fernsehgeräts solange verfolgen, bis er auf dem betreffenden Bildanzeigefeld eines von ihm danach gewünschten Programms ein Bild aus der ihn interessierenden Sendung dieses Programms erkennt. Bei den oft gegebenen Zeitverschiebungen der Sendungen braucht der Benutzer also nicht probeweise auf das andere Programm umschalten und wieder zurückschalten, wenn die interessierende Sendung noch nicht begonnen hat.

Darüber hinaus erhält der Benutzer einen bildlichen Überblick über alle im Moment laufenden Ssendungen der anderen Programme. Dies erspart ihm ein oftmaliges Durchsehen der Programmzeitschrift.

In bevorzugter Ausgestaltung der Erfindung erscheinen die Bildsignale als sich zyklisch aktualisierende Standbilder auf den Bildanzeigefeldern. Vorzugsweise erscheinen die Standbilder aller wählbaren Programme gleichzeitig auf den Bildanzeigefeldern.

In einer Ausgestaltung der Erfindung ist die Empfangsschaltung ein Infrarot-Empfänger, der von einem Infrarot-Sender des Fernsehgeräts die Bildsignale empfängt. Die Bildsignale aller auswählbaren Fernsehprogramme werden dabei im Fernsehgerät erzeugt und von einem an diesem vorgesehenen Infrarot-Sender zu dem Infrarot-Empfänger des Fernbediengeräts abgestrahlt. Die Übertragung erfolgt digitalisiert, wobei die Signale jedes Bildes gegenüber dem Original-Fernsehbild reduziert sind, so daß die Bandbreite des IR-Kanals ausreichend ist.

In einer anderen Ausgestaltung der Erfindung weist die Empfangsschaltung einen Tuner auf und leitet aus Fernsehantennensignale die Bildsignale der auswählbaren Fernsehprogramme ab. In diesem Fall ist die Erzeugung der Bildsignale unabhängig von dem Fernsehgerät. Diese Ausführung eignet sich somit für die Zuordnung zu einem Fernsehgerät, das die Bildsignale nicht erzeugt.

In bevorzugter Ausgestaltung der Erfindung decken sich jede Programmwahltaste und das ihr zugeordnete Bildanzeigefeld örtlich. Der Benutzer braucht sich dann am Fernbediengerät nicht zu orientieren, welches der Bildanzeigefelder welcher Programmwahltaste zugeordnet ist. Durch einen Druck auf das Bildanzeigefeld, das ein Bild aus der gewünschten Sendung zeigt, wird das Fernsehgerät auf diese Sendung umgeschaltet.

Jedes Bildanzeigefeld kann von einem eigenen LC-Display gebildet sein. Dieses ist dann mit der Programmwahltaste integriert. Es ist auch möglich, für alle Bildanzeigefelder ein einziges LC-Display vorzusehen. Die Programmwahltasten insgesamt sind in diesem Fall von einer durchsichtigen Folientastatur oder einer Sensortastatur gebildet. Eine derartige Tastatur ist beispielsweise in den Konferenzunterlagen ED 87 Internationale Ausstellung und Konferenz, Wiesbaden 14.-16.10.1987, Herausgeber: Network GmbH, Hagenburg 1987 beschrieben.

Ausführungsbeispiele ergeben sich aus der folgenden Beschreibung. In der Zeichnung zeigen:
Figur 1 eine Aufsicht einer ersten Ausführung eines Fernbediengeräts,
Figur 2 eine Aufsicht einer zweiten Ausführung eines Fernbediengeräts,
Figur 3 ein Blockschaltbild eines Fernbediengeräts mit zugeordnetem Fernsehgerät in einer ersten Ausgestaltung,
Figur 4 ein Blockschaltbild eines Fernsehgeräts für ein Fernbediengerät nach Figur 5
   und
Figur 5 ein Fernbediengerät in einer gegenüber Figur 3 vereinfachten Ausgestaltung.

Ein Fernbediengerät (1) weist ein Gehäuse (1') mit einem infrarotdurchlässigen Fenster (2) auf. An dem Gehäuse (1') sind Programmwahltasten (3) in Zeilen (4) und Spalten (5) angeordnet. Jede der Programmwahltasten (3) deckt sich mit einem Bildanzeigefeld (6). Im Beispielsfalle sind je sechzehn Programmwahltasten (3) und Bildanzeigefelder (6) in vier Zeilen (4) und vier Spalten (5) angeordnet. Selbstverständlich können auch mehr oder weniger Programmwahltasten und Bildanzeigefelder vorgesehen sein. Mittels einer Doppelfunktionstaste (7) läßt sich eine Umschaltung in der Weise vornehmen, daß mit den sechzehn Programmwahltasten (3) und den sechzehn Bildanzeigefeldern (6) zweiunddreißig Programme wählbar und anzeigbar sind. Mittels der Programmwahltasten (3) wird in üblicher Weise das Fernsehprogramm eines Fernsehgeräts eingeschaltet. Weitere Tasten (8) dienen der Steuerung von weiteren Funktionen des Fernsehgeräts.

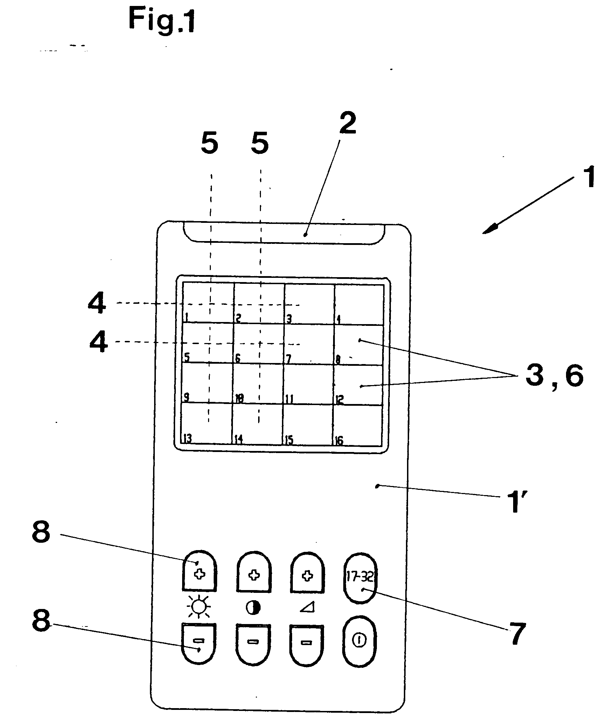

Bei der Ausführung nach Figur 1 sind alle Bildanzeigefelder (6) von einem einzigen LC-Display gebildet. Dieses läßt sich durch elektronische Steuermittel in die einzelnen Bildanzeigefelder aufteilen. Auf dem LC-Display ist eine Folientastatur angeordnet, die die Programmwahltasten (3) enthält. Anstelle der Folientastatur kann auch eine Sensortastatur vorgesehen sein. Die Tastatur ist durchsichtig, damit die Bildanzeigefelder (6) deutlich sichtbar sind. Die Tastatur kann auf eine den Frontpolarisator des LC-Displays bildende Scheibe aufgeklebt sein.

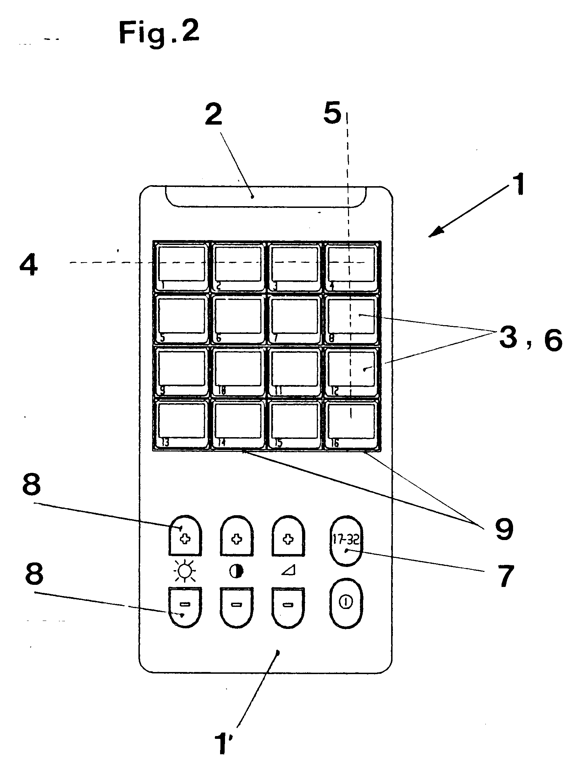

Beim Ausführungsbeispiel nach Figur 2 weisen die Programmwahltasten (3) Tastenkappen (9) auf. In jede Tastenkappe (9) ist ein eigenes, ein Bildanzeigefeld (6) bildendes LC-Display eingebaut. Die Programmwahltasten (3) haben bei dieser Ausführung einen deutlich fühlbaren Hub.

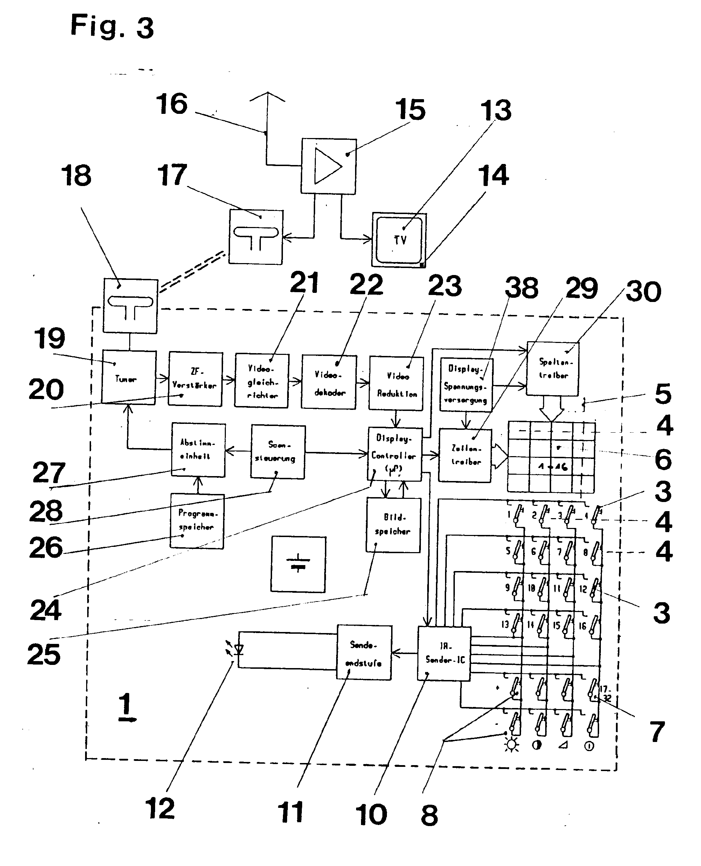

Das Fernbediengerät (1) weist nach dem Blockschaltbild entsprechend Figur 3 einen Infrarot-Sender-IC (10), eine Sendeendstufe (11) und eine Infrarot-Sendediode (12) auf. An den Sender (10) sind die Programmwahltasten (3) und die weiteren Tasten (7,8) angeschlossen.

Ein Fernsehgerät (13) ist mit einem Infrarot-Empfänger (14) versehen, der die Signale der Infrarot-Sendediode (12) empfängt und dementsprechend das Fernsehgerät (13) steuert. Das Fernsehgerät (13) ist über einen Antennenverstärker (15) mit einer Hausantenne (16) verbunden. An eine Antennenbuchse ist eine Zimmer-Sendeantenne (17) angeschlossen, welche das Fernsehantennensignal im Zimmer abstrahlt. Das Fernbediengerät (1) weist eine Antenne (18) auf, welche das Fernsehantennensignal der Zimmerantenne (17) empfängt. Die Zimmer-Sendeantenne (17) kann entfallen, wenn zu erwarten ist, daß für die Antenne (18) ein hinreichendes Fernsehsignal zur Verfügung steht.

Der Antenne (18) sind ein Tuner (19), ein ZF-Verstärker (20), ein Videogleichrichter (21), ein Videodecoder (22) und eine Schaltung (23) zur Reduzierung des vollen Videosignals nachgeschaltet. Die am Ausgang der Schaltung (23) anstehenden Bildsignale werden über eine Steuerschaltung (24), die beispielsweise von einem Mikroprozessor gebildet ist, in einen Bildspeicher (25) eingelesen.

Das Fernbediengerät (1) weist einen Programmspeicher (26) auf, in dem die mittels der Programmwahltasten (3) wählbaren Programme gespeichert sind. Dieser wirkt auf eine an den Tuner (19) angeschlossene Abstimmeinheit (27). Die Abstimmeinheit (27) wird von einer Fortschaltsteuerung (28) (Scansteuerung) so angesteuert, daß der Tuner (19) zyklisch nacheinander die im Programmspeicher (26) gespeicherten Programme bzw. Frequenzen empfängt. Die Fortschaltsteuerung (28) ist auch an die Steuerschaltung (24) angeschlossen, so daß das Bild des jeweils empfangenen Programms an dem hierfür vorgesehenen Platz des Bildspeichers (25) abgelegt wird. Gesteuert durch die Fortschaltsteuerung (28) wird etwa alle 2 bis 5 s jeweils ein neues Bild des betreffenden Programms in dem Bildspeicher (25) abgelegt.

Die Steuerschaltung (24) weist einen Zeilentreiber (29) und einen Spaltentreiber (30) auf, mit denen die Bildanzeigefelder (6) ansteuerbar sind. Von der Steuerschaltung (24) wird aus dem Bildspeicher (25) das dem jeweiligen Programm zugehörige, in diesem kurz zuvor gesendete Bild auf das betreffende Bildanzeigefeld (6) gelegt. Für den Benutzer erscheinen dabei an den im Beispielsfalle sechzehn Bildanzeigefeldern (6) gleichzeitig Bilder aus Sendungen, die über die Programmwahltasten (3) am Fernsehgerät (13) auswählbar sind.

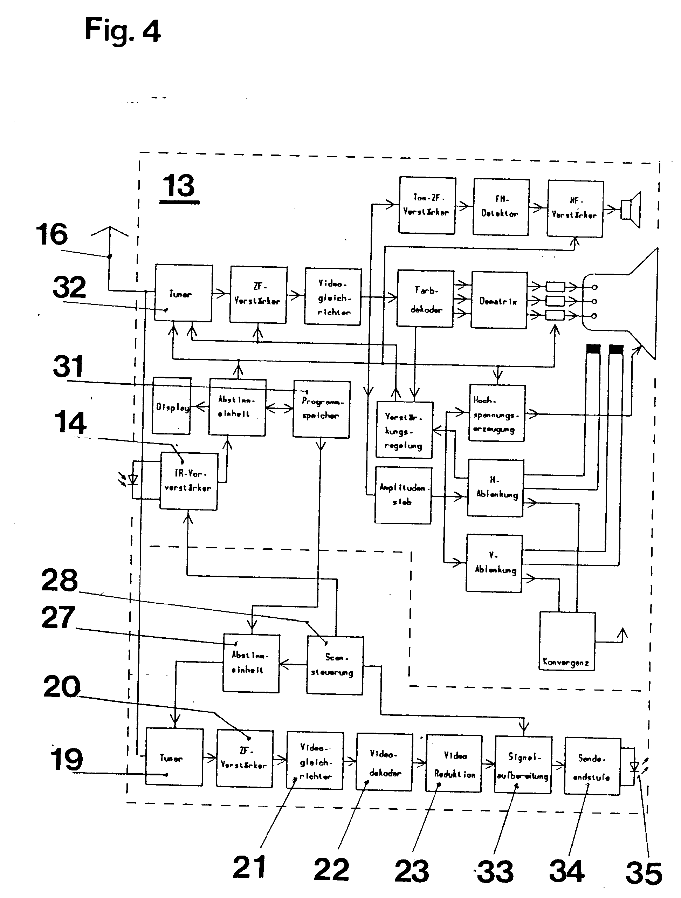

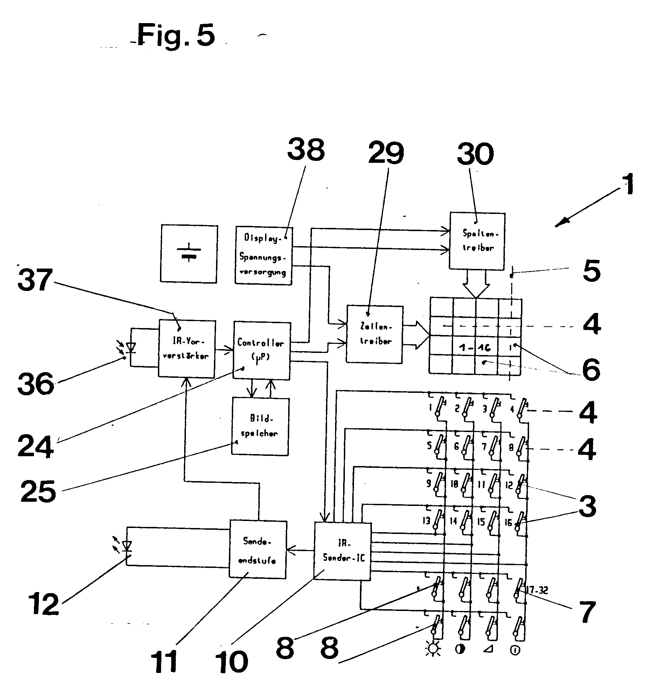

Bei dem Ausführungsbeispiel nach Figur 4 und 5 sind die Baugruppen (19 bis 23 und 27, 28), die beim Ausführungsbeispiel nach Figur 3 Bestandteil des Fernbediengeräts (1) sind, Bestandteil des Fernsehgeräts (13) (vgl. Figur 4). Das Fernsehgerät (13) weist diese Baugruppen zusätzlich zu seinen üblichen Baugruppen auf, die in Figur 4 gezeigt sind, jedoch nicht näher beschrieben werden müssen. An die Abstimmeinheit (27) ist ein im Fernsehgerät (13) ohnehin vorhandener Programmspeicher (31) angeschlossen. Das Fernsehgerät (13) weist neben seinem Tuner (32), der für den Empfang des ausgewählten Programms vorgesehen ist, den Tuner (19) als weiteren Tuner auf. Beide Tuner (19, 32) liegen an der gleichen Antenne (16). Der Schaltung (23) sind eine Signalaufbereitungsschaltung (33) und eine Sendeendstufe (34) mit Infrarot-Sendediode (35) nachgeschaltet. Die Signalaufbereitungsschaltung (33) ist von der Fortschaltsteuerung (28) gesteuert. Die Fortschaltsteuerung (28) ist auch an den Infrarot-Empfänger (14) angeschlossen. Sie stellt damit sicher, daß nicht gleichzeitig ein Infrarotsignal gesendet und empfangen wird.

Die von der Sendediode (35) des Fernsehgeräts (13) gesendeten Bildsignale der Sendungen der wählbaren Programme werden von einer Infrarot-Empfangsdiode (36) des Fernbediengeräts (1) empfangen (vgl. Figur 5) und in einem Vorverstärker (37) verstärkt. Dieser ist an die Steuerschaltung (24) angeschlossen. Wie oben beschrieben, werden die Bildsignale in dem Bildspeicher (25) abgelegt und über den Zeilentreiber (29) und den Spaltentreiber (30) auf die Bildanzeigefelder (6) übertragen. Die Sendeendstufe (11) ist mit dem Vorverstärker (37) verbunden, um ein gleichzeitiges Senden und Empfangen zu verhindern.

Bei den Ausführungen nach den Figuren 3 und 5 ist eine Spannungsversorgung (38) für das bzw. die LC-Displays vorgesehen, das bzw. die die Bildanzeigefelder (6) bilden.

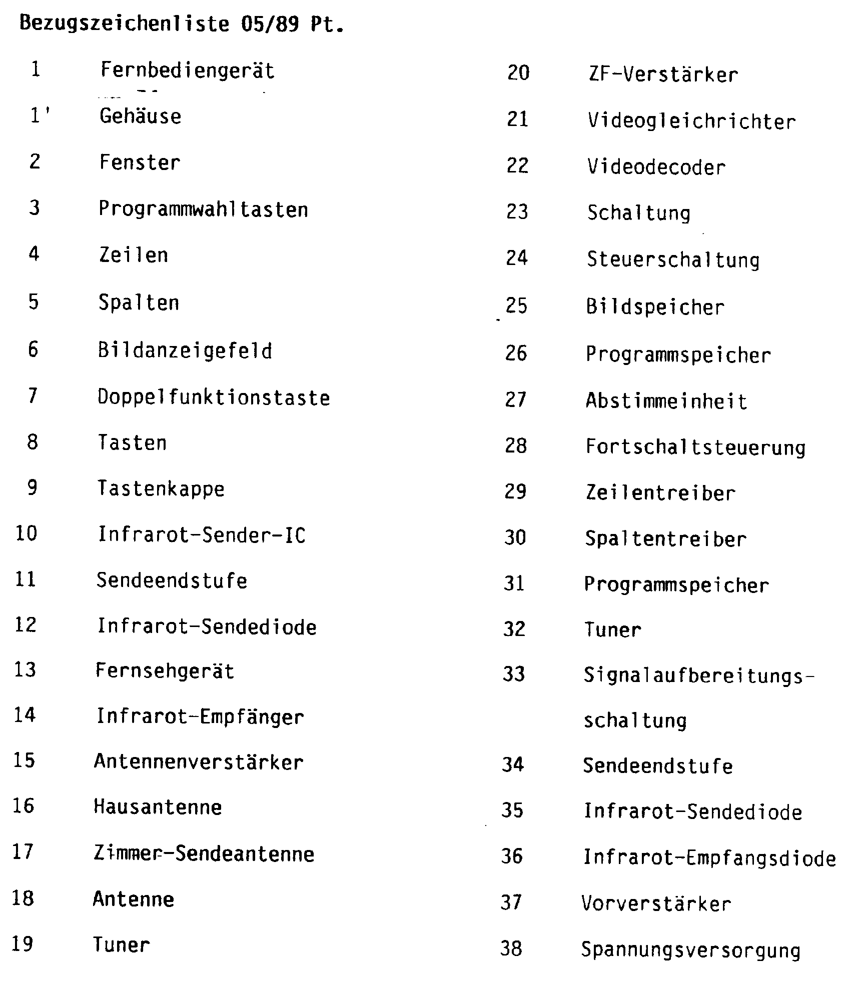

## Patentansprüche

1. Fernbediengerät für ein Fernsehgerät mit mehreren Programmwahltasten und mit einer Infrarot-Sendeschaltung, die Signale betätigter Tasten zum Fernsehgerät abstrahlt,
dadurch gekennzeichnet,
daß das Fernbediengerät (1) eine Empfangsschaltung aufweist, die Bildsignale der mittels der Programmwahltasten (3) auswählbaren Fernsehprogramme erfaßt, wobei ein Speicher (25) diese Bildsignale erforderlichenfalls speichert, daß jeder Programmwahltaste (3) am Fernbediengerät ein Bildanzeigefeld (6) zugeordnet ist und daß eine Steuerschaltung (24, 29, 30) die Bildsignale aus dem Speicher (25) zyklisch auf die Bildanzeigefelder (6) verteilt.

2. Fernbediengerät nach Anspruch 1,
dadurch gekennzeichnet,
daß die Empfangsschaltung ein Infrarot-Empfänger (36, 37) ist, der von einem Infrarot-Sender (34, 35) des Fernsehgeräts (13) die Bildsignale empfängt.

3. Fernbediengerät nach Anspruch 1,
dadurch gekennzeichnet,
daß die Empfangsschaltung einen Tuner (19) aufweist und aus Fernsehantennensignalen die Bildsignale der auswählbaren Fernsehprogramme ableitet.

4. Fernbediengerät nach einem der vorhergehenden Ansprüche,
dadurch gekennzeichnet,
daß die Bildsignale als sich zyklisch aktualisierende Standbilder auf den Bildanzeigefeldern (6) erscheinen.

5. Fernbediengerät nach einem der vorhergehenden Ansprüche,
dadurch gekennzeichnet,
daß die Standbilder aller wählbaren Programme gleichzeitig auf den Bildanzeigefeldern (6) erscheinen.

6. Fernbediengerät nach einem der vorhergehenden Ansprüche,
dadurch gekennzeichnet,
daß sich jede Programmwahltaste (3) und das ihr zugeordnete Bildanzeigefeld (6) örtlich decken.

7. Fernbediengerät nach Anspruch 6,
dadurch gekennzeichnet,
daß jedes Bildanzeigefeld (6) von einem eigenen LC-Display gebildet ist.

8. Fernbediengerät nach Anspruch 6,
dadurch gekennzeichnet,
daß ein einziges LC-Display alle Bildanzeigefelder (6) bildet.

## Claims

1. Remote-control device for a television set having several programme selection keys and an infrared transmitter circuit which reflects signals of actuated keys to the television set,
characterised in that
the remote-control device (1) has a receiver circuit which picks up image signals of the television programmes which can be selected by means of the programme selection keys (3), wherein a memory (25) stores these image signals if necessary, in that an image display panel (6) is associated with each programme selection key (3) on the remote-control device, and in that a control circuit (24, 29, 30) distributes the image signals cyclically from the memory (25) to the image display panels (6).

2. Television set according to claim 1,
characterised in that
the receiver circuit is an infrared receiver (36, 37) which receives the image signals from an infrared transmitter (34, 35) of the television set (13).

3. Television set according to claim 1,
characterised in that
the receiver circuit has a tuner (19) and derives the image signals of the selectable television programmes from television antenna signals.

4. Television set according to one of the preceding claims,
characterised in that
the image signals appear as cyclically actualisising stationary images on the image display panels (6).

5. Television set according to one of the preceding claims,
characterised in that
the stationary images of all the selectable programmes appear simultaneously on the image display panels (6).

6. Television set according to one of the preceding claims
characterised in that
each programme selection key (3) and the image display panel (6) associated with it locally overlap.

7. Television set according to claim 6,
characterised in that
each image display panel (6) is formed from an individual LC display.

8. Television set according to claim 6,
characterised in that
a single LC display forms all the image display panels (6).

## Revendications

1. Appareil de télécommande pour un téléviseur, comprenant plusieurs touches de sélection de programme et un circuit d'émission à l'infrarouge, qui rayonne,vers le téléviseur, des signaux de touches actionnées, caractérisé en ce que l'appareil de télécommande (1) présente un circuit de réception,qui capte.des signaux d'image des programmes de télévision choisissables au moyen des touches (3) de sélection de programme, qu'une mémoire (25) stocke au besoin ces signaux d'image, qu'une zone de visualisation (6) est coordonnée à chaque touche de sélection de programme (3) sur l'appareil de télécommande et qu'un circuit de commande (24, 29, 30) répartit les signaux d'image de la mémoire (25) de façon cyclique sur les zones de visualisation (6).

2. Appareil de télécommande selon la revendication 1, caractérisé en ce que le circuit de réception est un récepteur infrarouge (36, 37) qui reçoit les signaux d'image d'un émetteur infrarouge (34, 35) du téléviseur (13).

3. Appareil de télécommande selon la revendication 1, caractérisé en ce que le circuit de réception comporte un syntoniseur (19) et dérive les signaux d'image des programmes de télévision choisissables à partir de signaux d'une antenne de télévision.

4. Appareil de télécommande selon une des revendications précédentes, caractérisé en ce que les signaux d'image apparaissent sur les zones de visualisation (6) comme des images arrêtées qui sont cycliquement actualisées.

5. Appareil de télécommande selon une des revendications précédentes, caractérisé en ce que les images arrêtées de tous les programmes choisissables apparaissent simultanément sur les zones de visualisation (6).

6. Appareil de télécommande selon une des revendications précédentes, caractérisé en ce que chaque touche de sélection de programme (3) et la zone de visualisation (6) qui lui est coordonnée, se recouvrent localement.

7. Appareil de télécommande selon la revendication 6, caractérisé en ce que chaque zone de visualisation (6) est formée par un affichage à cristaux liquides qui lui est propre.

8. Appareil de télécommande selon la revendication 6, caractérisé en ce qu'un seul affichage à cristaux liquides forme toutes les zones de visualisation (6).
